# EUROPEAN PATENT APPLICATION

(11) **EP 4 471 499 A1**
(43) Date of publication of application: **04.12.2024**
(21) Application number: 23177098.3
(22) Date of filing: 02.06.2023
(51) Int. Cl.: G03F 1/24, G03F 1/72

(54) **ML REFLECTIVITY MODIFICATION**

(71) Applicant: Carl Zeiss SMS Ltd., 2015600 Misgav (IL)
(72) Inventor: DMITRIEV, Vladimir, 2015600 D.N. Misgav (IL); OSHEMKOV, Sergey, 2015600 D.N. Misgav (IL); GUSAROV, Alexander, 2015600 D.N. Misgav (IL); COHEN, Avi, 2015600 D.N. Misgav (IL)
(74) Representative: Bardehle Pagenberg Partnerschaft mbB Patentanwälte Rechtsanwälte

(57) **Abstract**

The present disclosure relates to a method for correcting a reflective lithography mask, wherein the mask (M) comprises a substrate (S) and a reflective multilayer stack (ML), the method comprising: applying a first electromagnetic radiation to the mask to evoke a first material change (C1) within the mask which modifies a reflectivity of the mask. The present disclosure further relates to an apparatus for correcting a reflective lithography mask and a reflective lithography mask.

## Description

### 1. Technical field

The present invention relates to correcting reflective lithography masks. In particular the invention relates to a method for correcting a reflective lithography mask, an apparatus for correcting a reflective lithography mask, and a reflective lithography mask.

### 2. Prior art

In the field of semiconductor technology, various lithography processes are known to generate structures on a sample (e.g., a wafer). The lithographic processes may comprise, for example, photolithography, ultraviolet (UV) lithography, DUV lithography (i.e., lithography in the deep ultraviolet spectral region), EUV-lithography (i.e., lithography in the extreme ultraviolet spectral region), x-ray lithography, etc.

Usually, a lithography process requires the use of a lithography mask (e.g., photomasks, exposure masks, reticles, etc.) which comprises a pattern to image desired structures on a sample. The imaging may be performed via a lithographic exposure system which illuminates the lithography mask with exposure light such that a lithographic image of the mask is projected onto a desired plane (e.g., a wafer plane).

Lithography processes with reflective lithography masks are gaining more importance in the semiconductor technology sector. For example, EUV-lithography may require the use of a reflective lithography mask wherein EUV-lithography enables the generation of increasingly smaller structures. A mechanism of a lithographic process with a reflective lithography mask may comprise that the exposure light is partially absorbed by pattern elements of the mask and reflected off the mask wherein the reflected light is used to generate the according lithographic image of the mask in the desired plane.

However, mask properties of reflective lithography masks may not always be ideal for a lithographic process. If a mask is not ideal the lithographic result with the mask may also be not ideal or even erroneous (e.g., out of specification).

For example, mask errors may be present in the mask (e.g., from production of the mask) which may result in optical errors in the lithographic image. For example, mask properties of a reflective mask may slightly deviate such that the lithographic image may not be optimal with respect to other lithographic processes that are performed to generate structures on the sample.

However, a lithography process with a reflective lithography mask (in particular in an industrial setting) should have process results within a given specification.

Therefore, there is a need to find improve ways to correct reflective lithography masks.

### 3. Summary of the invention

The aspects described herein address the above need at least in part.

A first aspect relates to a method for correcting a reflective lithography mask comprising: applying a first electromagnetic radiation to the mask to evoke a first material change within the mask which modifies a reflectivity of the mask.

For example, applying the first electromagnetic radiation may comprise initially shaping the first electromagnetic radiation, e.g., by setting one or more specific electromagnetic radiation parameters. For example, a specific electromagnetic radiation parameter may comprise a power, a power density, an energy and/or a fluence of the first electromagnetic radiation. A specific electromagnetic radiation parameter may also comprise a pulse parameter of the first electromagnetic radiation (e.g., a pulse width, a pulse repetition rate and/or a pulse density of the first electromagnetic radiation). In an example, a specific electromagnetic radiation parameter may comprise a wavelength of the first electromagnetic radiation. In an example, a specific electromagnetic radiation parameter may comprise a numerical aperture (of an optical system) associated with the first electromagnetic radiation. Furthermore, applying the first electromagnetic radiation may comprise guiding the first electromagnetic radiation into the mask onto a desired location within the mask. For example, the guiding may be implemented by one or more optical elements that may affect the orientation and/or direction of the first electromagnetic radiation.

The applying of the first electromagnetic radiation may be performed such that a desired spot size of the first electromagnetic radiation occurs in a specific depth of the mask. For example, the applying of the first electromagnetic radiation may comprise focusing the first electromagnetic radiation onto the desired spot size at the specific depth of the mask.

In an example, the applying of the first electromagnetic radiation may be performed such that an effective volume is formed within the mask by the first electromagnetic radiation where conditions are met such that the first material change is evoked.

For example, the applying of the first electromagnetic radiation may induce heat within the mask (e.g., within the effective volume) wherein the heat evokes the first material change. Notably, the heat may evoke a chemical and/or physical reaction that leads to the first material change. In an example, the first material change may comprise the generation of a structure having a different material composition and/or density than the surrounding mask material which has not experienced the first material change. For example, depending on the triggered reaction the density may be increased or decreased compared to the surrounding material. In an example, the first material change may comprise a local melting of a material within the mask.

The first material change may comprise a persistent change. In an example, the first material change may persevere over a prolonged period of time. For example, the first material change may persist to such an extent that the presence of the first material change may be verified over a prolonged period of time (e.g., after 1 day, after 1 week, after 1 month, after 1 year, after 10 years, after 20 years, etc.).

The first material change within the mask may affect the mask such that the reflectivity of the mask is changed. For example, the different material composition and/or density of the first material change may be of a critical magnitude which impacts the reflectivity of the mask.

Hence, by purposefully applying the first electromagnetic radiation to the mask the reflectivity of the mask may be modified in a defined manner according to the herein described disclosure. For example, the method may comprise evoking a first material change within the mask to generate a desired (e.g., predetermined) reflectivity.

Notably, in the prior art it is rather known to modify the planarity of a reflective mask in a defined manner. For example, US2017010540A1 teaches to locally deposit energy from light pulses of a light beam in the substrate of an EUV-mask for generating a predetermined 3D contour of the EUV-mask.

The herein described approach may, however, rather enable to tune the reflectivity of a reflective mask into a defined state.

In an example, the reflectivity of the mask may comprise a reflectivity with respect to the wavelength of the lithographic procedure the reflective lithographic mask is configured for. For example, the mask may be configured for a lithographic procedure with a specific exposure wavelength λ_{E}. Hence, during a lithographic procedure the mask may be exposed with light having the specific exposure wavelength λ_{E} to generate a lithographic image. As the mask is a reflective lithography mask the light having the specific exposure wavelength λ_{E} will be reflected off the mask. The application of the first electromagnetic radiation may evoke a first material change such that the reflectivity of the mask is modified for light having the specific exposure wavelength λ_{E}. In accordance, the modified reflectivity may thus modify the lithographic image for a lithographic procedure with the specific exposure wavelength λ_{E}.

To that regard, the method may be applied for correcting a lithographic image of the mask. For example, by purposefully applying the first electromagnetic radiation to the mask the reflectivity of the mask may be modified in a defined manner to correct (e.g., optimize) a lithographic image of the mask. In an example, correcting the reflective lithography mask (as described herein) may also be regarded as correcting a lithographic image of the mask.

Notably, the herein described approach may enable a further degree of freedom to correct a reflective lithographic mask (or a lithographic image thereof) by adapting the reflectivity of the mask.

For example, prior art may rather be limited to adapt other properties of a reflective lithography mask. For example, a correction of a reflective lithography mask is widely known wherein the absorption of the reflective mask is changed (e.g., via an electron beam induced etching and/or deposition). However, the herein described disclosure addresses how to effectively adapt another key parameter of a reflective lithography mask - namely the reflectivity of the reflective mask.

In an example, the first electromagnetic radiation may have a wavelength which is not the same as the specific exposure wavelength λ_{E} the mask is configured for. Namely, this may avoid that the first electromagnetic radiation is substantially reflected off the mask.

In an example, the first electromagnetic radiation may comprise laser light.

In an example the first electromagnetic radiation may be applied such that the reflectivity of the mask is locally modified. For example, the method may comprise applying the first electromagnetic radiation to the mask such that a local reflectivity change (e.g., a spatially delimited reflectivity change) is induced to the mask. Hence, the reflectivity of the mask may, for example, only be adapted for a subarea or subvolume of the mask. The herein described approach may thus not be limited to a global reflectivity change. According to the herein described approach a variety of local reflectivities may be generated throughout the mask.

In an example, the first material change may be regarded as a first type of material change. For example, the first electromagnetic radiation may be guided onto a plurality of locations within the mask wherein at each location a first type of material change occurs. At each location the physical and/or chemical reaction may be based on the same mechanism (e.g., a heat evoked change of a specific material). However, at each location the first electromagnetic radiation may be varied (e.g., by varying one or more specific electromagnetic radiation parameters of the first electromagnetic radiation). This may enable that at each location a different magnitude of the first material change may be evoked. For example, a different extent of the density change may occur depending on the chosen specific electromagnetic radiation parameters, wherein the induced material composition may be substantially the same.

Illustratively speaking, the first type of material change may also be regarded as a first type of pixel that can be written into the mask. However, the herein described approach may not always be implemented such that the first material change can be spatially seen as a pixel such that the terminology pixel may not apply for all examples of the disclosure.

For example, the method may comprise applying the first electromagnetic radiation to a first location within the mask with a first set of specific electromagnetic radiation parameters. This may evoke a first material change (or first type of material change) with a first magnitude (e.g., a first local density increase). The method may further comprise applying the first electromagnetic radiation to a second location within the mask with a second set of specific electromagnetic radiation parameters (which are different from the first set of specific electromagnetic radiation parameters). This may evoke a first material change (or first type of material change) with a second magnitude which is different from the first magnitude (e.g., a second local density increase which is different from the first local density increase).

Hence, at two locations within the mask the same first type of material change may be evoked, however with a different extent. This may allow for a wide degree of spatial adaptation of the mask's reflectivity and thus for a wide degree of locally correcting the reflective lithography mask.

In an example, two different locations where the first type of material change was evoked may also have the same magnitude of the first material change. In an example, at the first location a local density increase may be evoked, whereas at the second location a local density decrease may be evoked. In a further example, at the first location a local compaction may be evoked, whereas at the second location a local expansion may be evoked.

In an example, the first type of material change (or first material change) may be generated at three or more, four or more, ten or more, 100 or more, and/or 1000 or more locations within the mask. For example, the first type of material change may be generated for at most 10000 locations, at most 5000 locations, at most 1000 locations, and/or at most 100 locations within the mask.

In an example, the first type of material change may be evoked in a continuous manner. For example, the first electromagnetic radiation may be guided in a scanning manner through an area within the mask. For example, the first electromagnetic radiation may be continuously guided along one or more axes. During said continuous sweep the one or more specific electromagnetic parameters may be varied (as described herein). Hence, a continuous change of the first type of material change may be evoked according to the herein described approach.

In an example, the first type of material change may be evoked in a discrete manner. For the discrete manner, the first electromagnetic radiation may be guided onto two or more locations of an area within the mask, wherein the two or more locations may be spatially separated (e.g., they may not overlap). At each location the first type of material change may be evoked, wherein the evoked first material change for each location is spatially separated from the first material change evoked at another location. The first electromagnetic radiation may thus step through various locations within the mask to generate spatially segregated first type of material changes. In such an example, the first type of material change may, for example, also be regarded as a first type of pixel.

In an example, the herein described aspects of the method involving a continuous manner and a discrete manner may be combined for correcting the reflective lithography mask. For example, a first area within the mask may be corrected in a continuous manner, wherein a second area of the mask may be corrected in a discrete manner.

Subsequently, exemplary values of specific electromagnetic radiation parameters which may be varied (e.g., depending on the desired magnitude of the first type of material change) are described.

In an example, a specific radiation parameter may comprise a wavelength of the first electromagnetic radiation. The wavelength of the first electromagnetic radiation may be between 150 nm and 1500 nm, between 500 nm and 1400 nm, between 800 and 1300 nm, and/or between 840 nm and 1100 nm.

In an example, a specific radiation parameter may comprise a pulse width of the first electromagnetic radiation. The pulse width of the first electromagnetic radiation may be between 100 fs to 100 ns, between 500 fs to 50 ns, between 800 fs to 20 ns, and/or between 1 ns to 20 ns.

In an example, a specific radiation parameter may comprise a beam spot size of the first electromagnetic radiation (within the mask). The beam spot size of the first electromagnetic radiation may be between 20 µm to 200 µm, between 20 µm to 100 µm and/or between 20 µm to 50 µm.

In an example, a specific radiation parameter may comprise a power density of the first electromagnetic radiation. The power density of the first electromagnetic radiation may be between 10 mJ/cm² to 1000 mJ/cm², 10 mJ/cm² to 500 mJ/cm², 10 mJ/cm² to 200 mJ/cm², 10 mJ/cm² to 100 mJ/cm². The power density of the first electromagnetic radiation may, for example, also be between 10 mJ/cm² to 1000 mJ/cm², 100 mJ/cm² to 1000 mJ/cm², 250 mJ/cm² to 1000 mJ/cm², 500 mJ/cm² to 1000 mJ/cm².

Notably, adapting the power density may be highly beneficial for the herein described method as the magnitude of the evoked first material change may, for example, be highly dependent on the power density of the first electromagnetic radiation.

In an example, the method may comprise applying the first electromagnetic radiation to a first location within the mask with a first power density. This may evoke a first material change (or first type of material change) with a first magnitude (e.g., a first local density increase). The method may further comprise applying the first electromagnetic radiation to a second location within the mask with a second power density (which may be different from the first power density). This may evoke a first material change (or first type of material change) with a second magnitude different from the first magnitude (e.g., a second local density increase different from the first local density increase).

In an example, a specific radiation parameter may comprise a pulse density of the first electromagnetic radiation. The pulse density may be a value of the number of pulses per area (e.g., with the unit pulse/mm²). For example, the pulse density may be between 1000 to 10'000'000 pulses per mm². For example, the pulse density may be between 1000 to 10'000'000 pulses per mm², 1000 to 5'000'000 pulses per mm², 1000 to 1'000'000 pulses per mm², 1000 to 500'000 pulses per mm², 1000 to 100'000 pulses per mm², and/or 1000 to 50'000 pulses per mm². For example, the pulse density may be between 1000 to 10'000'000 pulses per mm², 2000 to 10'000'000 pulses per mm², 5000 to 10'000'000 pulses per mm², 10'000 to 10'000'000 pulses per mm², and/or 100'000 to 10'000'000 pulses per mm².

In an example, the mask may comprise a substrate and a reflective multilayer stack. As described herein, the first electromagnetic radiation may be applied to such a mask to evoke a first material change within the mask which modifies the reflectivity of the mask.

For example, the substrate may be a base material of the reflective mask which has various further layers coupled thereto (e.g., the reflective multilayer stack). In an example, the substrate may have a substantially mechanical and/or thermal function for the mask (e.g., to enable a secure clamping and/or chucking of the mask and/or a thermal management of heat). In an example, the substrate may be a layer of the mask which by design of the mask may not function to have a substantial impact on the optical image of the mask. For example, the substrate may not be designed to have an impact on the reflectivity of the mask. The mask may be on the backside of the mask, wherein a coating of one or more layers may be applied to the substrate.

For example, the reflective multilayer stack may be configured to function as a reflective mirror for the specific exposure wavelength λ_{E} of the mask (as described herein). The reflective multilayer stack may thus, for example, be a main contributor for the reflectivity of the reflective mask. The reflective multilayer stack may comprise one or more reflector layers which may contribute to the mask's reflectivity for a lithographic process. For example, the reflective multilayer stack may be configured as a Bragg mirror (or distributed Bragg reflector).

In an example the first electromagnetic radiation may be applied such that the first material change occurs within the reflective multilayer stack.

Hence, the herein described method may comprise evoking the first material change within the reflective multilayer stack of the mask. This may be highly beneficial for modifying the reflectivity of the mask since the first material change is evoked in a layer which actively contributes to the reflectivity of the mask. The effect of the first material change on the reflectivity may thus be more pronounced since the first material change is a material change of the reflective multilayer stack. The reflectivity may thus be directly modified. Hence, an indirect modification may be avoided where a material is modified which may not (by design) contribute to the mask's reflectivity. Such an indirect modification may not always lead to a desired correction of the lithographic image. According to the herein described disclosure, the first type of material change may be evoked in various locations within the reflective multilayer stack with different magnitudes.

In an example the first electromagnetic radiation may be applied such that the first material change occurs within the substrate. Hence, the herein described method may comprise evoking the first material change within the substrate to modify the reflectivity of the mask. For example, the first material change may be generated in a vicinity of an interface of the reflective multilayer stack (e.g., the reflective multilayer stack may border on the substrate forming an according interface at the border). For example, the first material change may be generated at a first predetermined distance from the interface. The first predetermined distance may be regarded as close to the interface of the reflective multilayer stack. The first predetermined distance may be chosen such that the first material change within the substrate may have an impact on the reflectivity of the mask (e.g., an impact on the reflectivity of the reflective multilayer stack).

The first predetermined distance may have a value in a range between 0 µm to 50 µm, 0 µm to 30 µm, 0 µm to 30 µm, 0 µm to 10 µm, 0 µm to 5 µm, and/or 0 µm to 2 µm.

In an example the mask may comprise a substrate and at least one further layer, wherein the first electromagnetic radiation is applied such that the first material change occurs within the at least one further layer. The at least one further layer may, for example, be designed to implement any function of the mask (e.g., an optical, mechanical and/or thermal function, etc.). According to the herein described approach the first material change may be applied to the at least one further layer to modify the reflectivity of the mask. The first material change may thus not necessarily be applied to the substrate of the mask.

In an example the at least one further layer may comprise a layer of the reflective multilayer stack of the mask (as described herein).

In an example, the reflectivity of the mask may be modified for a pattern area of the mask. For example, a pattern area may be an area of the mask where pattern elements (which may absorb the exposure light) are positioned. According to the herein described disclosure the first electromagnetic radiation may be used to modify the reflectivity within the pattern area. Hence, in the lithographic image the image of the pattern area may be corrected (whereas other image areas may not be corrected, for example).

In an example, the herein described reflective lithography mask may comprise a reflective lithography mask for extreme-ultraviolet (EUV) lithography. Such a mask may also be referred to as an EUV-mask.

In an example, the reflectivity may be modified such that at least one critical dimension (CD) of a lithographic image of the mask is adapted. For example, the evoked first type of material change may be positioned within the mask such that a CD of the lithographic image of the mask is corrected (e.g., improved). For example, by adapting the reflectivity of the mask in a defined manner (as described herein) the intensity distribution of the lithographic image may be adapted. Said mechanism may be used to accordingly adapt a CD of the lithographic image. For example, a CD may comprise a width of a pattern element of the mask in the lithographic image which is defined by an according intensity distribution. By adapting the reflectivity of the mask, a CD of the mask (e.g., a corresponding intensity distribution) may be adjusted.

Said mechanism may also be used to adapt the CD uniformity (CDU) throughout the lithographic image.

The modification of the at least one CD may also be termed CD correction process (CDC process). To that regard the first electromagnetic radiation may be used to evoke a CDC process.

In an example, the modification of the at least one CD may further be based at least in part on the same principles as known for transmissive masks. However, in transmissive masks rather the optical transmission may be adapted to adjust for the CD. Such principles for CD correction (CDC) for transmissive masks are disclosed in US9436080B2, US2020124959A1, US2012009511A1. In an example, US9436080B2 is incorporated by reference in its entirety to the herein described disclosure. In an example, US2020124959A1 is incorporated by reference in its entirety to the herein described disclosure. In an example, US2012009511A1 is incorporated by reference in its entirety to the herein described disclosure.

In an example the first material change may further modify at least one other property of the mask besides the reflectivity. The at least other property of the mask may be modified in a defined manner. For example, the method may comprise setting a defined reflectivity and a defined other property of the mask via the first material change. As described herein, the first material change may be regarded as a first type of material change.

To illustrate an according example, a single first type of material change may be evoked (e.g., a single spatially separated pixel) which modifies the reflectivity and the at least one other property of the mask in a defined manner. In such an example, each first type of material change may thus contribute to both factors (the reflectivity and the at least on other property of the mask).

To illustrate a further example, in a first step a first type of material change (e.g., a single spatially separated pixel) may be evoked which may substantially only modify the reflectivity. For said first step a first set of specific electromagnetic radiation parameters may be used. The first step may comprise evoking a first type of material change at a first location within the mask. In a second step another first type of material change (e.g., a further single spatially separated pixel) may be evoked which may substantially only modify the at least one other property of the mask. The first step may comprise evoking a first type of material change at a second location within the mask. For said second step a second set of specific electromagnetic radiation parameters may be used which is different from the first set. For example, the first set of specific electromagnetic radiation parameters may have a different power density than the second set of specific electromagnetic radiation parameters. For example, the first set of specific electromagnetic radiation parameters may have a different pulse density than the second set of specific electromagnetic radiation parameters.

In an example, the first location may be different from the second location. However, it may also be conceivable that the second location is the same as the first location.

In an example the at least one other property may comprise at least one of the following: a compaction of the mask; a position of a pattern element on the mask; a flatness of the mask.

For example, the at least one other property may comprise a compaction of the mask. The compaction may comprise a local compaction which may have been introduced to the mask via the first electromagnetic radiation by modifying the mask's reflectivity. Said compaction may be modified via the first electromagnetic radiation, as well.

In an example (as described herein), a single first type of material change may modify the reflectivity and the compaction. For example, a single pixel may modify the reflectivity and the compaction. It may be predetermined that the introduced reflectivity change would result in a certain compaction. This may be accounted for by adapting the pixel such that (instead) a desired compaction of the mask occurs.

In another example (as also described herein), in a first step a first type of material change may be evoked which may mainly modify reflectivity, in a second step a first type of material change may be evoked which may mainly modify the compaction. For example, a first pixel may substantially modify the reflectivity, wherein a second pixel may substantially modify the compaction. For example, the second pixel may introduce an expansion to the mask. It may be predetermined that the introduced reflectivity change would result in a certain compaction over the mask. This may be accounted for by incorporating pixels into the mask which substantially alter the compaction of the mask to a desired state.

For example, the at least one other property may comprise a position of a pattern element on the mask. The position of the pattern element may have been altered via the first electromagnetic radiation by modifying the mask's reflectivity. Therefore, the position of the pattern element be modified via the first electromagnetic radiation, as well.

In an example (as described herein), a single first type of material change may modify the reflectivity and the position of the pattern element. For example, a single pixel may modify the reflectivity and the position of the pattern element. It may be predetermined that the introduced reflectivity change would result in a certain change in the pattern element. This may be accounted for by adapting the pixel such that (instead) a desired position of the pattern element occurs.

In another example (as also described herein), in a first step a first type of material change may be evoked which may mainly modify reflectivity, in a second step a first type of material change may be evoked which may mainly modify the position of the pattern element. For example, a first pixel may substantially modify the reflectivity, wherein a second pixel may substantially modify the position of the pattern element. For example, the second pixel may introduce an expansion to the mask which may shift the pattern element to a desired position. It may be predetermined that the introduced reflectivity change would result in a certain change of the position of the pattern element. This may be compensated for by incorporating pixels into the mask which substantially influence the position of the pattern element.

For example, the at least one other property may comprise a flatness of the mask. A flatness may comprise deviations from an ideal flat surface plane of the mask. The flatness of the mask may have been altered via the first electromagnetic radiation by modifying the mask's reflectivity. Therefore, the flatness may be modified via the first electromagnetic radiation, as well.

In an example (as described herein), a single first type of material change may modify the reflectivity and the flatness. For example, a single pixel may modify the reflectivity and the flatness. It may be predetermined that the introduced reflectivity change would result in a certain change in the flatness. This may be accounted for by adapting the pixel such that (instead) a desired flatness occurs.

In another example (as also described herein), in a first step a first type of material change may be evoked which may mainly modify reflectivity, in a second step a first type of material change may be evoked which may mainly modify the flatness. For example, a first pixel may substantially modify the reflectivity, wherein a second pixel may substantially modify the flatness. For example, the second pixel may introduce an expansion or compression to the mask which may adapt the flatness of the mask. It may be predetermined that the introduced reflectivity change would result in a certain change of flatness. This may be compensated for by incorporating pixels into the mask which substantially influence the flatness.

In an example, the bow of the mask which may be a part of the flatness may not be modified. Namely, the bow of the mask may be addressed via an according chucking.

The herein described modifying of the compaction, the position of the pattern element and/or the flatness may also be termed registration correction process (REGC process). To that regard the first electromagnetic radiation may be used to evoke a REGC process. Such a registration correction process (REGC process) may further be based at least in part on the according technical principles described in the following documents US9436080B2, US2020124959A1, US2012009511A1 (which are incorporated by reference in their entirety to this disclosure, as mentioned).

In an example the method may further comprise applying a second electromagnetic radiation to the mask to evoke a second material change within the mask such that at least one property of the mask is modified.

All aspects described herein for the first electromagnetic radiation may also be accordingly applied to the second electromagnetic radiation. All aspects described herein for the first material change within the mask may also be accordingly applied to the second material change within the mask.

Applying the second electromagnetic radiation may be regarded as a further process step for correcting the reflective lithography mask. For example, the second electromagnetic radiation may be applied to the mask in a continuous and/or discrete manner (as described herein for the first electromagnetic radiation) to further correct the mask.

In an example, the second material change may also be regarded as a specific type of material change. For example, the second electromagnetic radiation may be guided onto a plurality of locations within the mask wherein at each location a specific type of material change occurs. At each location the physical and/or chemical reaction may be based on the same mechanism (e.g., a heat evoked change of a specific material). However, at each location the second electromagnetic radiation may be varied (e.g., by varying one or more specific electromagnetic radiation parameters of the second electromagnetic radiation). This may enable that at each location a different magnitude of the second material change may be evoked. For example, a different extent of the density change may occur depending on the chosen specific electromagnetic radiation parameters, wherein the induced material composition may be substantially the same.

The specific type of material change may be the same as the first type of material change. For example, the physical and/or chemical reaction induced by the second electromagnetic radiation may substantially be the same reaction induced by the first electromagnetic radiation. This may be the case when the first and second electromagnetic radiation is applied to the same material of the mask.

In another example, the specific type of material change may be different from the first type of material change. For example, the physical and/or chemical reaction induced by the second electromagnetic radiation may substantially be different than the reaction induced by the first electromagnetic radiation. This may be the case when the first and second electromagnetic radiation is applied to a different material of the mask.

In an example, a specific electromagnetic radiation parameter of the second electromagnetic radiation may be different from a specific electromagnetic radiation parameter of the first electromagnetic radiation.

For example, a power density of the second electromagnetic radiation may be different from the power density of the first electromagnetic radiation.

For example, a pulse density of the second electromagnetic radiation may be different from the pulse density of the first electromagnetic radiation.

In an example the second electromagnetic radiation may be applied such that the second material change occurs within the substrate.

For example, the first electromagnetic radiation may be applied such that the first material change occurs within the reflective multilayer stack, wherein the second electromagnetic radiation may be applied such that the second material change occurs within the substrate.

For example, the first electromagnetic radiation may be applied such that the first material change occurs within the substrate, wherein the second electromagnetic radiation may be applied such that the second material change occurs within the substrate.

In an example the second electromagnetic radiation may be applied such that the second material change occurs within the reflective multilayer stack.

For example, the first electromagnetic radiation may be applied such that the first material change occurs within the reflective multilayer stack, wherein the second electromagnetic radiation may be applied such that the second material change occurs within the reflective multilayer stack.

For example, the first electromagnetic radiation may be applied such that the first material change occurs within the substrate, wherein the second electromagnetic radiation may be applied such that the second material change occurs within the reflective multilayer stack.

In an example the at least one property may be modified to reduce a deviation of the mask introduced by applying the first electromagnetic radiation. For example, the second electromagnetic radiation may be used to evoke a second material change within the mask which may compensate (e.g., minimize or eliminate) the deviation.

In an example the at least one property (which may be modified by the second electromagnetic radiation) may comprise at least one of the following: an error of the mask which cannot be corrected during lithography; a compaction of the mask; a position of a pattern element on the mask; a flatness of the mask; the reflectivity of the mask, at least one critical dimension of a lithographic image of the mask.

In an example, the at least one property may be modified to reduce the deviation introduced by applying the first electromagnetic radiation.

For example, the at least one property (which may be modified by the second electromagnetic radiation) may comprise an error of the mask which cannot be corrected during lithography. For example, some errors may be corrected during lithography by the exposure system (e.g., by a scanner). To that regard, errors of the mask which may not be correct during lithography may be termed non-correctable errors (NCE) in the lithography field. The application of the second electromagnetic radiation may be used to evoke a second material change which may modify the amount of NCE. For example, the second material change may be used to reduce the NCE which were introduced by the first electromagnetic radiation.

For example, the at least one property (which may be modified by the second electromagnetic radiation) may comprise a compaction of the mask. The compaction of the mask may have been introduced by the application of the first electromagnetic radiation. In an example, this compaction may not have been addressed by the first electromagnetic radiation. Hence, the second electromagnetic radiation may be used to evoke a second material change which may reduce the undesired compaction of the mask. As described herein, a modification of the compaction may comprise a REGC process.

For example, the at least one property (which may be modified by the second electromagnetic radiation) may comprise a position of a pattern element on the mask. The position of the pattern element may have been changed by the application of the first electromagnetic radiation. In an example, the position of the pattern element may not have been addressed by the first electromagnetic radiation. Hence, the second electromagnetic radiation may be used to evoke a second material change which may shift the pattern element to a desired location. As described herein, a modification of the position of the pattern element may comprise a REGC process. Notably, the method may also comprise changing the positions of a plurality of pattern elements. The adaptation of the position of a pattern element (as described herein) may be needed to enable a desired overly during a lithographic process. The overlay may, for example, comprise an on-product-overlay (OPO) as known in the field. In an example, the first and/or second electromagnetic radiation may be used to adjust the OPO to a desired value (e.g., such that the OPO is within a predetermined specification).

For example, the at least one property (which may be modified by the second electromagnetic radiation) may comprise a flatness of the mask. The flatness of the mask may have been changed by the application of the first electromagnetic radiation. In an example, the flatness of the mask may not have been addressed by the first electromagnetic radiation. Hence, the second electromagnetic radiation may be used to evoke a second material change which may adapt the flatness to a desired state. As described herein, a modification of the flatness may comprise a REGC process.

In an example, the second electromagnetic radiation may modify the flatness without including the bow (as the bow may be addressed by an according chucking).

For example, the at least one property (which may be modified by the second electromagnetic radiation) may comprise the reflectivity of the mask. For example, the first electromagnetic radiation may evoke a first material change which imparts a first reflectivity change to the mask. Subsequently, the second electromagnetic radiation may evoke a second material change which imparts a second reflectivity change to the mask which may then result in an overall modification of the reflectivity of the mask.

As described herein, two or more properties of the mask may be modified via the second electromagnetic radiation. For example, the second electromagnetic radiation may be used to modify an error of the mask which cannot be corrected during lithography, and a position of a pattern element. For example, the second electromagnetic radiation may be used to modify a position of a pattern element, and a flatness of the mask.

Notably, the second electromagnetic radiation may induce a REGC process which may modify the registration and/or the flatness of the mask.

In an example, the mask may be measured after the first electromagnetic radiation was applied to measure the at least one property of the mask. Based on the measurement the at least one property may be modified via the application of the second electromagnetic radiation.

In an example the first and second electromagnetic radiation may be applied simultaneously to the mask.

In an example, the second electromagnetic radiation may be applied after the first electromagnetic radiation was applied to the mask.

In an example the first electromagnetic radiation may be applied from a side of the mask which comprises a pattern element for lithography; and/or the second electromagnetic radiation may be applied from a backside of the mask. The side of the mask which comprises the pattern element may be regarded as the front side of the mask. The backside of the mask may be the opposite side of the frontside.

For example, a first step may comprise applying the first electromagnetic radiation from the frontside of the mask to modify the reflectivity of the mask. A second step may comprise applying the second electromagnetic radiation from the backside of the mask to modify the reflectivity of the mask. Such a procedure may, for example, be used to adapt the CD of the mask with the frontside process and with the backside process, as well. In an example, the frontside process may evoke a first material change within the reflective multilayer stack, wherein the backside process may evoke a second material change within the reflective multilayer stack, as well. The first and second material change may be spatially separated (e.g., residing within different depths of the multilayer stack). Also, other combinations may be conceivable wherein the frontside process and the backside process may evoke their respective material changes in the multilayer stack and the substrate or only in the substrate.

As described herein, the second electromagnetic radiation applied from the backside may also be used to adapt other properties of the mask.

In an example the second electromagnetic radiation may be applied from the side of the mask which comprises a pattern element for lithography; and/or the first electromagnetic radiation may be applied from the backside of the mask. Thus, the first electromagnetic radiation may be applied with a backside process wherein the second electromagnetic radiation may be applied with a frontside process.

In an example the method may further comprise applying a third electromagnetic radiation to the mask to evoke a third material change within the mask such that at least one property of the mask is modified.

All aspects described herein for the first and/or second electromagnetic radiation may also be accordingly applied to the third electromagnetic radiation. All aspects described herein for the first and/or second material change within the mask may also be accordingly applied to the third material change within the mask.

Applying the third electromagnetic radiation may be regarded as a further process step for correcting the reflective lithography mask. As described herein, the third electromagnetic radiation may be applied to the mask in a continuous and/or discrete manner (as described herein for the first electromagnetic radiation) to further correct the mask. For example, the third electromagnetic radiation may be used to correct a deviation induced by the first and/or second electromagnetic radiation.

For example, the first electromagnetic radiation may be applied such that the first material change occurs within the reflective multilayer stack, wherein the second electromagnetic radiation may be applied such that the second material change occurs within the substrate, wherein the third electromagnetic radiation may be applied such that the third material change occurs within the reflective multilayer stack.

For example, the first electromagnetic radiation may be applied such that the first material change occurs within the reflective multilayer stack, wherein the second electromagnetic radiation may be applied such that the second material change occurs within the substrate, wherein the third electromagnetic radiation may be applied such that the third material change occurs within the reflective substrate.

For example, the first electromagnetic radiation may be applied such that the first material change occurs within the reflective multilayer stack, wherein the second electromagnetic radiation may be applied such that the second material change occurs within the reflective multilayer stack, wherein the third electromagnetic radiation may be applied such that the third material change occurs within the substrate.

For example, the first electromagnetic radiation may be applied such that the first material change occurs within the substrate, wherein the second electromagnetic radiation may be applied such that the second material change occurs within the substrate, wherein the third electromagnetic radiation may be applied such that the third material change occurs within the substrate.

In an example, the herein described applying of a particular type of electromagnetic radiation (or the applying of a combination of particular types of electromagnetic radiation) may be regarded as a writing procedure, as typically the applying may be implemented as one process block (e.g., within an industrial setting).

A second aspect relates to an apparatus for correcting a reflective lithography mask comprising: means for applying a first electromagnetic radiation to the mask to evoke a first material change within the mask which modifies a reflectivity of the mask. The apparatus may further comprise a control unit which may comprise a computer program for performing the method of the first aspect. The control unit may thus control the apparatus to perform a method of the first aspect. For example, the control unit may be configured to adapt the means for applying the first electromagnetic radiation such that it evokes a first material change within the multilayer stack and/or within the substrate.

A third aspect relates to a reflective lithography mask, wherein the mask was corrected by a method of the first aspect.

A fourth aspect relates to a computer program for performing the method of the first aspect.

It is noted that the method steps (or computer program steps) as described herein may comprise all aspects described herein, even if not expressly described as method steps but rather with reference to an apparatus (or device or system). Moreover, the apparatus (or systems or devices) as outlined herein may comprise means for implementing all aspects as outlined herein, even if these may rather be described in the context of method steps (or computer program steps).

Whether described as method steps, computer program and/or means, the functions described herein may be implemented in hardware, software, firmware, and/or combinations thereof. If implemented in software/firmware, the functions may be stored on or transmitted as one or more instructions or code on a computer-readable medium. Computer-readable media include both computer storage media and communication media including any medium that facilitates transfer of a computer program from one place to another. A storage medium may be any available media that can be accessed by a general purpose or special purpose computer. By way of example, and not limitation, such computer-readable storage media can comprise RAM, ROM, EEPROM, FPGA, CD/DVD or other optical disk storage, magnetic disk storage or other magnetic storage devices, or any other medium that can be used to carry or store desired program code means in the form of instructions or data structures and that can be accessed by a general-purpose or special-purpose computer, or a general-purpose or special-purpose processor. The control unit as described herein may also be implemented in hardware, software, firmware, and/or combinations thereof, for example, by means of one or more general-purpose or special-purpose computers, and/or a general-purpose or special-purpose processors.

### 4. Short description of the figures

- **Fig. 1**: shows an exemplary reflective lithography mask for EUV-lithography.
- **Fig. 2**: shows a first example of a corrected mask according to the disclosure.
- **Fig. 3**: shows a second example of a corrected mask according to the disclosure.
- **Fig. 4**: shows a third example of a corrected mask according to the disclosure.
- **Fig. 5**: shows a fourth example of a corrected mask according to the disclosure.
- **Fig. 6**: shows a fifth example of a corrected mask according to the disclosure.
- **Fig. 7**: shows a sixth example of a corrected mask according to the disclosure.

### 5. Detailed description of the figures and embodiments

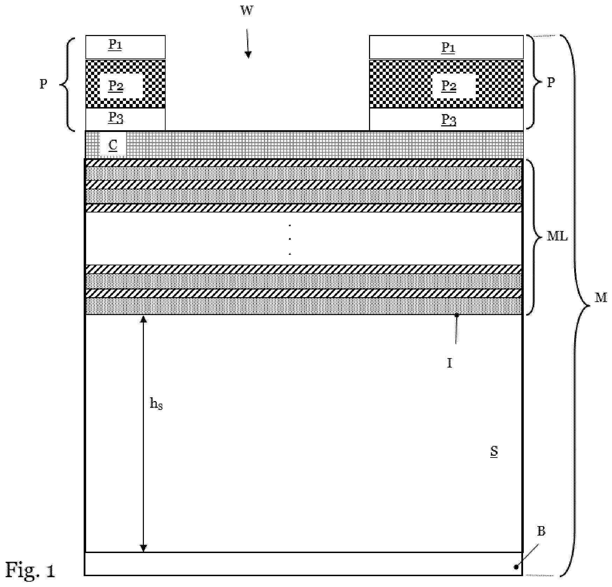

Fig. 1 shows an exemplary reflective lithography mask M for EUV-lithography. Subsequently, the exemplary reflective lithography mask is referred to as EUV-mask M. However, the herein described teaching may be applied to any reflective lithography mask (and may not be limited to a particular type of reflective lithography mask).

The EUV-mask M of Fig. 1 may comprise a substrate S. The EUV-mask M may further comprise a reflective multilayer stack ML. The reflective multilayer stack ML may comprise alternating reflector layers (as schematically illustrated in Fig. 1). The reflective multilayer stack ML may be configured to be reflective for the light used for EUV-Lithography. For example, the reflective multilayer stack ML may be reflective for a specific exposure wavelength of 13.5 nm. The reflective multilayer stack may be configured as a Bragg mirror.

In an example, the reflective multilayer stack ML may have a border with the substrate S. The border may also be regarded as an interface I between the reflective multilayer stack ML and the substrate S.

The EUV-mask M may further comprise a capping layer C. The capping layer C may adjoin the reflective multilayer stack ML. For example, the capping layer C may function as a protection of the reflective multilayer stack ML.

The EUV-Mask M may further comprise one or more pattern elements P. A pattern element P may be configured to absorb the specific exposure wavelength used during EUV-lithography. Hence, the one or more pattern elements may be used to generate a lithographic image with a desired pattern. In the example of Fig. 1 the pattern element P may comprise three pattern element layers P1, P2, P3. The first pattern element layer P1 may comprise an antireflection coating. The second pattern element layer P2 may comprise a material which substantially contributes to the absorption of the specific exposure wavelength. The second pattern element layer P2 may be regarded as an absorption layer. The third pattern element layer P3 may be a stabilizing layer (e.g., used for mechanical, optical and/or thermal purposes). Notably, the disclosure may not be limited to the schematic EUV-Mask M of Fig. 1**.** For example, an EUV-mask may not necessarily comprise pattern elements with three pattern element layers. An EUV-mask may also have pattern elements comprising of only one pattern element layer (e.g., only one absorption layer) or may comprise only two pattern element layers.

The EUV-mask M may further comprise a backside layer B. The backside layer B may adjoin the substrate S. The backside layer B may be electrically conductive to enable an improved chucking.

During EUV-lithography the EUV-mask M may be irradiated with an exposure light W from the frontside of the mask comprising the pattern elements P (as indicated in Fig. 1). As described, the exposure light may comprise the specific exposure wavelength (e.g., 13.5 nm). The exposure light may be partially absorbed by the pattern elements P and may partially enter the reflective multilayer stack ML. As the reflective multilayer stack may function as a mirror, the exposure light is reflected off the EUV-mask for areas which do not comprise a pattern element. In other words, if the exposure light W was not absorbed by a pattern element P the reflective multilayer stack ML ensures that said light is reflected off the mask. Hence, the reflectivity of the reflective multilayer stack ML may have a significant impact on the lithographic image of the EUV-mask M.

Hence, the reflective multilayer stack may function as a main contributor to the reflectivity of the EUV-mask. An error in the EUV-masks M reflectivity may adversely impact the quality of the lithographic image of the EUV-mask. In some cases, it may thus be desired to adapt the EUV-Mask (e.g., its reflectivity).

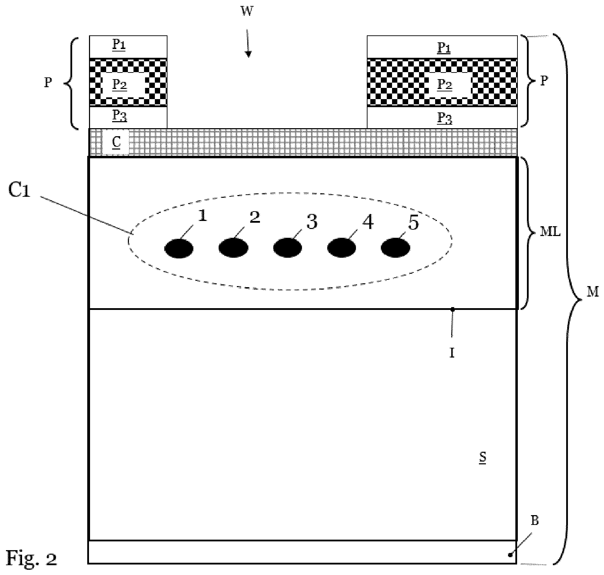

Fig. 2 shows a first example of a corrected mask according to the herein described method. In this example, a corrected EUV-Mask M is shown.

As described the method may comprising applying a first electromagnetic radiation to the mask to evoke a first material change within the mask which modifies a reflectivity of the mask. In the example of Fig. 2 the first material change C1 is evoked in the reflective multilayer stack ML.

In this example, the first material change C1 may comprise discrete pixels 1, 2, 3, 4, 5 which have been written to the reflective multilayer stack. The method is thus implemented in a discrete manner (as described herein). Each pixel 1, 2, 3, 4, 5 may be a spatially separated material change compared to the surrounding (substantially unmodified) material of the reflective multilayer stack ML. Each pixel may have an impact on the local reflectivity of the EUV-mask M. For example, each pixel may locally alter the reflectivity of the reflective multilayer stack ML. The first electromagnetic radiation may have been applied such that for each pixel a physical and/or chemical reaction is induced which may change the local density. For example, each pixel may have a high local density than the surrounding material. Each local density increase may locally adapt the reflectivity of the EUV-mask M. Each pixel may have a different contribution to the local reflectivity change (as described herein).

For example, the first pixel 1 may have been irradiated with the first electromagnetic radiation having first set of specific radiation parameters (as described herein). The second pixel 2 may have been irradiated with the first electromagnetic radiation having a second set of specific radiation parameters (as described herein). The first set may be different from the second set such that the local reflectivity change of the first pixel 1 may be different from the local reflectivity change of the second pixel 2. For example, the power density used for generating the first pixel 1 may be different from the power density used for generating pixel 2.

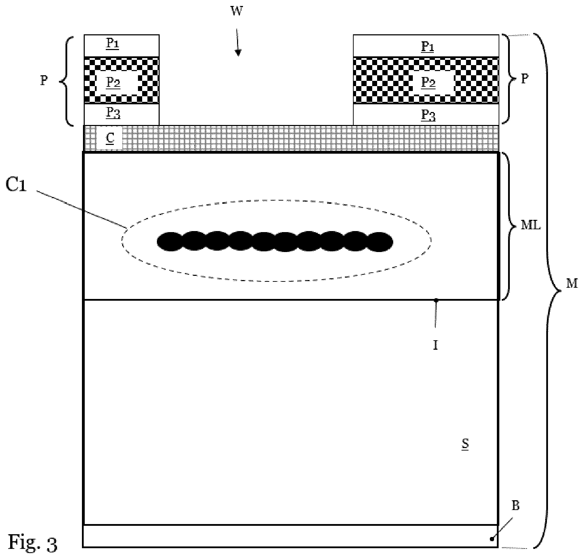

Fig. 3 shows a second example of a corrected mask according to the herein described method. In this example, a corrected EUV-Mask M is shown. In the example of Fig. 2 the first material change C1 is also evoked in the reflective multilayer stack ML.

However, in this example, the first material change C1 is present in a continuous manner. Namely, in Fig. 3 the method is implemented in a continuous manner (as described herein). In the continuous approach, the pixels generated via the first electromagnetic radiation may overlap such that spatially segregated material changes may not always be present. For example, a continuous change in the material within a certain area of the reflective multilayer stack ML may rather be generated.

As described herein, the evoked material change within the reflective multilayer stack may be used to correct at least one CD of a lithographic image of the EUV-mask M. For example, the first material change may locally alter the reflective multilayer stack which may locally alter the reflectivity of the EUV-mask which may adapt a CD of an optical image generated with the EUV-mask. For example, the evoked first material change C1 may adapt the intensity distribution of the EUV-mask M such that an image of a pattern element P is corrected.

The applying of the first electromagnetic radiation within the reflective multilayer stack ML may thus comprise (or be referred to) as a CDC process.

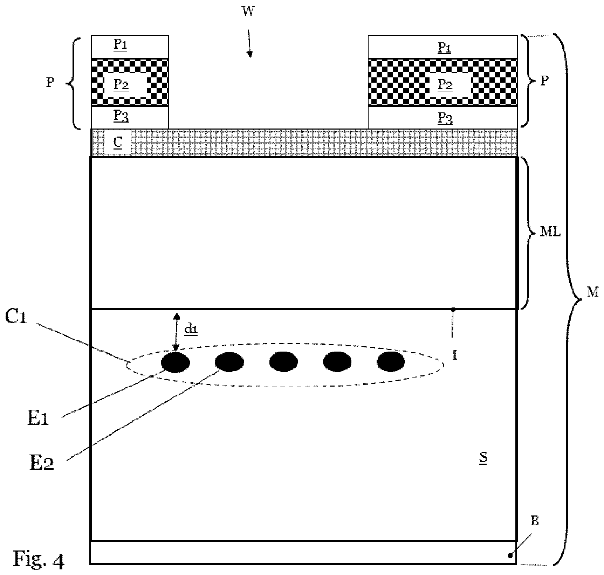

Fig. 4 shows a third example of a corrected mask according to the herein described method. In this example, a corrected EUV-Mask M is shown. In the example of Fig. 2 the first material change C1 is evoked in the substrate S. To that regard discrete pixel are shown (however, the method may also be applied in a continuous manner). In this example, the first material change C1 is evoked in a vicinity of the interface I (the border between the reflective multilayer stack ML and the substrate S). As described herein, the first material change may thus be regarded as close to the reflective multilayer stack ML (or close to the interface I of the reflective multilayer stack ML). As shown, the first material change C1 may be in a first predetermined distance d1 to the interface I. The first predetermined distance d1 may be chosen such that the first material change C1 within the substrate may have an impact on the reflectivity of the EUV-mask M (as described herein). For example, the evoked pixels in the substrate S of the first material change may evoke a local modification of the reflective multilayer stack ML and thus of the EUV-mask M.

The first predetermined distance may have a value in a range between 0 µm to 50 µm, 0 µm to 30 µm, 0 µm to 30 µm, 0 µm to 10 µm, 0 µm to 5 µm, and/or 0 µm to 2 µm (as described herein). In another example, the first predetermined distance may be smaller than 50 % of the height of the substrate, smaller than 30 % of the height of the substrate, smaller than 20 % of the height of the substrate, smaller than 10 % of the height of the substrate S, and/or smaller than 5 % of the height of the substrate. The height of the substrate S may comprise the height of the substrate defined by the substrate's extension along a normal vector of the reflective lithographic mask (e.g., an EUV-mask M). The height of the substrate S is also indicated in Fig. 1 as the height h_{S}.

Coming back to the example of Fig. 4, the first predetermined distance d1 may be varied for each pixel. For example, a first pixel may have different distance to the interface I than a second pixel. This may enable a further degree of freedom for correcting reflective lithography masks (e.g., EUV-masks). The first predetermined distance d1 may also be termed writing distance. Hence, for each pixel (or each type of first material change) a specific writing distance to the interface may be chosen. This may enable a further degree of freedom to affect a correction of the mask. For example, the induced reflectivity change may be further varied by adjusting the writing distance for a pixel.

In an example, the pixels induced by the first material change C1 in the vicinity of the interface I may have different functions. The different function may be evoked via different sets of specific electromagnetic radiation parameters of the first electromagnetic radiation.

For example, a first pixel E1 may mainly contribute to a desired reflectivity change of the EUV-mask M. A second pixel E2 may mainly contribute to a desired registration change of the EUV-mask (e.g., a change in a position of a pattern element P).

For example, the first pixel E1 may be evoked with a certain power density of the first electromagnetic radiation such that a local density increase of the mask material may be evoked. The local density increase may (locally) adapt the reflectivity of the EUV-mask M. This may be used to adapt a CD of the lithographic image to a desired state. However, the local density increase may induce an isotropic compaction within the EUV-mask M. This may result in an undesired registration change (e.g., an undesired change in a position of a pattern element P) and/or an undesired flatness change.

A second pixel E2 may (to that regard) be evoked with a certain pulse density of the first electromagnetic radiation such that a local expansion of the mask material may be evoked. The local expansion may (locally) correct the undesired registration change and/or the undesired flatness change induced by the first pixel E1 (which was used for a CD change).

Notably, the method may comprise generating a plurality of pixels within the EUV-Mask M and may not be limited to two pixels. For example, a first number of pixels may be used to generate a desired reflectivity change, wherein a second number of pixels may be used to generate a desired registration change and/or flatness change of the EUV-mask (as described herein). The second number of pixels may, for example, be generated to compensate the deviations induced by the first number of pixels. A simultaneous modification of the reflectivity of the reflective multilayer stack ML and a modification of the compaction of the EUV-mask may thus be enabled.

According to the herein described disclosure, a pixel characteristic may be varied depending on the power density or the pulse density of the first electromagnetic radiation, as well as the writing distance of the pixel to the interface I.

For example, if the power density is above a predetermined power threshold a reflectivity change may be induced (e.g., via a local compaction).

For example, if the pulse density is chosen to be within a predetermined pulse density range a registration change and/or flatness change may be induced (e.g., via a local expansion).

Adapting the writing distance of a pixel may further vary its induced effect on the EUV-mask M. For example, the writing distance may further adapt the induced reflectivity change, the induced registration change and/or flatness change.

The herein described method may thus enable a wide degree of freedom to correct a EUV-mask M.

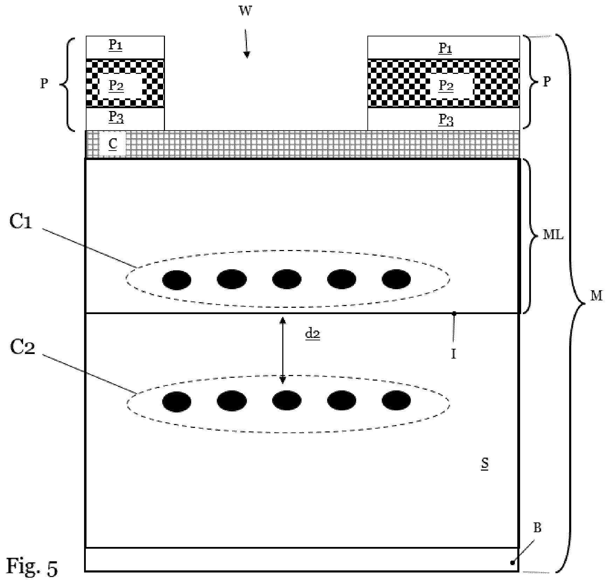

Fig. 5 shows a fourth example of a corrected mask according to the herein described method. In this example, a corrected EUV-Mask M is shown. In this example, the first electromagnetic radiation is applied to the reflective multilayer stack ML to evoke a first material change C1 in the reflective multilayer stack ML. For example, the pixels of the first material change C1 may be evoked as described with respect to Fig. 2 (or Fig. 3).

The writing of the pixels into the reflective multilayer stack ML may have been implemented to correct the reflectivity of the EUV-mask M. However, an undesired deviation of the mask may have been introduced by the first material change C1.

Therefore, the method may comprise applying a second electromagnetic radiation to the substrate to evoke a second material change C2 which may compensate the deviation induced by the first material change C1.

For example, the pixels of the second material change C2 may compensate non-correctable errors (NCEs) induced by the first material change C1.

For example, the pixels of the second material change C2 may compensate a registration change induced by the first material change C1.

For example, the pixels of the second material change C2 may compensate a flatness change induced by the first material change C1.

For example, the pixels of the second material change may compensate a flatness change induced by the first material change C1, wherein a bow change of the EUV-mask may not be compensated.

For example, the pixels of the second material change C2 may compensate a registration change and a flatness change induced by the first material change C1.

For example, the pixels of the second material change C2 may be generated in a second predetermined distance d2 to the interface I. In this example, as the second material change C2 may not be used to affect the reflectivity, it may not be necessary to position the pixels in a vicinity of the interface I. The second material change C2 may thus be evoked deeper within the substrate. However, it may also be conceivable to evoke the second material change C2 in this example, in the vicinity of the interface I (in a first predetermined distance d1 to the interface I).

As described herein, the applying of the second electromagnetic radiation may comprise (or be termed) a post REGC process to compensate for the induced deviation of the first change C1.

For example, the first material change C1 may introduce a certain number of quantifiable errors to the lithographic image of the EUV-mask M. The quantifiable errors may, for example, be measured. The quantifiable error may for example comprise NCE's, overlay errors or any other type of known and quantifiable lithographic error. It was found out that with the herein described post REGC processes the quantifiable errors induced by the first material change C1 could be reduced by at least 90 %. With certain settings of the post REGC processes the quantifiable errors induced by the first material change C1 could even be reduced by at least 99 % (in some examples even by 100 %).

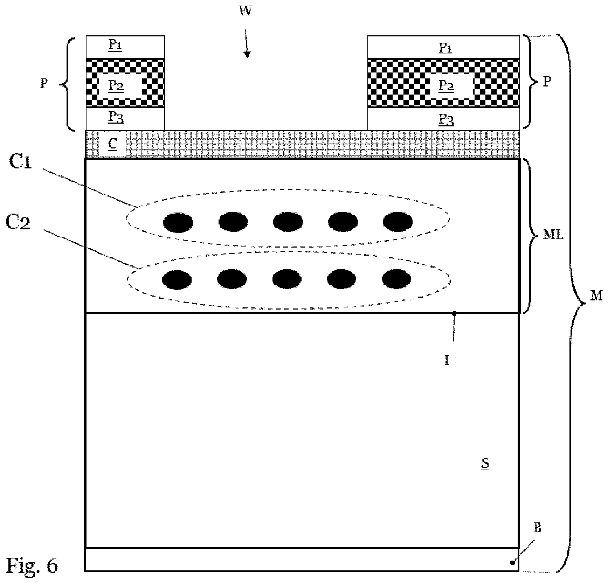

Fig. 6 shows a fifth example of a corrected mask according to the herein described method. In this example, a corrected EUV-Mask M is shown. In this example, the first electromagnetic radiation induces a first material change C1 within the reflective multilayer stack ML, wherein a second electromagnetic radiation induces a second material change C2 within the reflective multilayer stack, as well. For example, the pixels of the first material change C1 may be evoked as described with respect to Fig. 2 (or Fig. 3). For example, the pixels of the second material change C1 may also be evoked as described with respect to Fig. 2 (or Fig. 3). The one or more pixels of the first material change C1 may be arranged in an approximate plane that is approximately parallel to a plane approximated by the one or more pixels of the second material change C2.

In the example of Fig. 6 the pixels of the first material change C1 may be generated via a front side process (as described herein). To that regard, the frontside may be the side of the EUV-mask M which comprises the pattern elements P. For example, the radiation source of the first electromagnetic radiation may be positioned at the frontside of the EUV-mask M for the front side process.

In the example of Fig. 6 the pixels of the second material change C2 may be generated via a back side process (as described herein). To that regard, the backside may be the side of the EUV-mask M which is opposite the side which comprises the pattern elements P. For example, the radiation source of the second electromagnetic radiation may be positioned at the backside of the EUV-mask M for the backside process.

For example, the frontside process and the backside process may take place simultaneously. In such an example, a first radiation source at the front side may generate the first electromagnetic radiation, wherein a second radiation source at the backside may generate the second electromagnetic radiation.

For example, the frontside process and the backside process may be performed sequentially. In such an example, it may be conceivable that the EUV-Mask M is accordingly positioned (e.g., turned the right way) to enable the frontside process or the backside process, respectively.

In the example of Fig. 6, the first material change C1 may be used to modify a reflectivity of the EUV-mask M. For example, the first material change C1 may modify a CD of an optical image of the EUV-mask M. For example, applying the first electromagnetic radiation may be a CDC process (as described herein).

In the example of Fig. 6, the second material change C2 may be used to further modify the reflectivity of the EUV-Mask M. For example, the second material change C2 may modify a CD of an optical image of the EUV-mask M. For example, applying the second electromagnetic radiation may also be a CDC process (as described herein).

Such an approach (evoking a first and second material change within the reflective multilayer stack ML) may enable to effectively reduce non-correctable errors (NCEs). For example, the NCE's may be less using the frontside and backside approach compared to only using a first material change. In another example, the second material change C2 may compensate for NCE's which are introduced by the first material change C1 (and vice versa).

Notably, the example of Fig. 6 may comprise a frontside CDC process (evoking the first material change C1) and a backside CDC process (evoking the second material change C2).

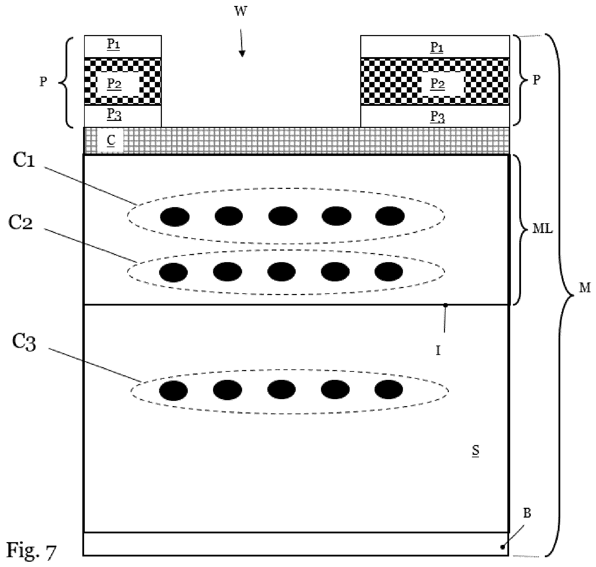

Fig. 7 shows a sixth example of a corrected mask according to the herein described method. In this example, a corrected EUV-Mask M is shown. In this example, a first electromagnetic radiation is applied to the EUV-mask M to evoke a first material change C1 within the reflective multilayer stack ML. A second electromagnetic radiation is applied to the EUV-mask M to evoke a second material change C2 within the reflective multilayer stack ML. A third electromagnetic radiation is applied to evoke a third material change C3.

In this example, the first material change C1 and the second material change C2 may comprise the material changes as described with respect to Fig. 6.

The process described in Fig. 6 may correct a CD of a lithographic image of the mask. However, this may induce a deviation of the EUV-mask M (which, e.g., was not present before). For example, (as described herein) the modification of the reflectivity of the EUV-mask may induce an undesired property of the mask. For example, the process of Fig. 6 may induce an undesired registration change and/or an undesired flatness change of the EUV-mask M.

This undesired property may be compensated via the evoked third material change C3 within the substrate S.

For example, the pixels of the third material change C3 may compensate non-correctable errors (NCEs) induced by the first material change C1 and/or the second material change C2.

For example, the pixels of the third material change C3 may compensate a registration change induced by the first material change C1 and/or the second material change C2.

For example, the pixels of the third material change C3 may compensate a flatness change induced by the first material change C1 and/or the second material change C2.

For example, the pixels of the third material change may compensate a flatness change induced by the first material change C1 and/or second material change C2, wherein a bow change of the EUV-mask may not be compensated.

For example, the pixels of the third material change C3 may compensate a registration change and a flatness change induced by the first material change C1 and/or the second material change C2.

As described herein, the applying of the third electromagnetic radiation may comprise (or be termed) a post REGC process to compensate for the induced deviation of the first and second material changes.

For example, the first material change C1 and second material change C2 may introduce a certain number of quantifiable errors to the lithographic image of the EUV-mask M. The quantifiable errors may, for example, be measured. The quantifiable error may for example comprise NCE's, overlay errors or any other type of known and quantifiable lithographic error. It was found out that with the herein described post REGC processes the quantifiable errors induced by the first material change C1 could be reduced by at least 90 %. With certain settings of the post REGC processes the quantifiable errors induced by the first material change C1 could even be reduced by at least 99 % (in some examples even by 100 %).

In general, the herein described methods may enable a correction of the EUV-mask M such that a lithographic image of the EUV-mask M is within a predetermined specification.

In the following further concepts of the herein described disclosure are given.

As described, a CDC process may be followed by a REGC process to compensate for scanner uncorrectables (e.g., NCE's).

In an example, a CDC process may be combined with a REGC process to correct both a registration and a CD problem of the EUV-mask M. For example, a first pixel type may mainly correct a registration problem, wherein a second pixel type may mainly correct a CD problem of the mask (as described herein).

In an example, one may perform a combination of front side and back side CDC processes to minimize residual scanner uncorrectables (e.g., NCE's).

The herein described concepts may improve versatility of the process and may improve the desired targets for CD, registration and/or flatness of an EUV-mask M.

For example, a REGC process in the substrate may be used to compensate for NCE's which resulted from a CDC process (which, e.g., comprises a material change in the reflective multilayer stack ML).

For example, a REGC process may be used to compensate for a registration change induced by a CDC process (which, e.g., comprises a material change in the reflective multilayer stack ML).

For example, a REGC process may be used to compensate for flatness change induced by a CDC process (which, e.g., comprises a material change in the reflective multilayer stack ML).

For example, a REGC process may be used to compensate for a flatness change induced by a CDC process (which, e.g., comprises a material change in the reflective multilayer stack ML), however a bow change of the EUV-mask M may not be compensated by the REGC process.

For example, a REGC process may be used to compensate simultaneously for a registration and flatness change induced by CDC process (which, e.g., comprises a material change in the reflective multilayer stack ML).

For example, a REGC process may be used in combination with a CDC process (wherein both processes may, e.g., evoke material changes in the substrate) to compensate simultaneously for high frequency reticle CD problems, REG problems and/or flatness problems.

For example, a combination of front side and back side CDC processes may be used to reduce resulting NCE's of each CDC process.

For example, a REGC process may be used in combination with a frontside CDC process and a backside CDC process wherein the REGC process may correct CD problems, REG problems and/or flatness problems (which may have been introduced by the frontside CDC process and backside CDC process).

## Claims

1. Method for correcting a reflective lithography mask (M), wherein the mask (M) comprises a substrate (S) and a reflective multilayer stack (ML), the method comprising:
applying a first electromagnetic radiation to the mask (M) to evoke a first material change (C1) within the mask which modifies a reflectivity of the mask (M).

2. Method according to claim 1, wherein the first electromagnetic radiation is applied such that the first material change (C1) occurs within the reflective multilayer stack (ML).

3. Method according to claim 1, wherein the first electromagnetic radiation is applied such that the first material change (C1) occurs within the substrate (S).

4. Method according to any of claims 1-3, wherein the reflectivity is modified such that at least one critical dimension of a lithographic image of the mask (M) is adapted.

5. Method according to any of claims 1-4, wherein the first material change (C1) further modifies at least one other property of the mask (M) besides the reflectivity.

6. Method according to claim 5, wherein the at least one other property comprises at least one of the following: a compaction of the mask (M); a position of a pattern element on the mask (M); a flatness of the mask (M).

7. Method according to any of claims 1-6, further comprising:
applying a second electromagnetic radiation to the mask to evoke a second material change (C2) within the mask (M) such that at least one property of the mask is modified.

8. Method according to claim 7, wherein the second electromagnetic radiation is applied such that the second material change (C2) occurs within the substrate (S).

9. Method according to claim 7, wherein the second electromagnetic radiation is applied such that the second material change (C2) occurs within the reflective multilayer stack (ML).

10. Method according to any of claims 7-9, wherein the at least one property is modified to reduce a deviation of the mask (M) introduced by applying the first electromagnetic radiation.

11. Method according to any of claims 7-10, wherein the at least one property comprises at least one of the following: an error of the mask (M) which cannot be corrected during lithography; a position of a pattern element on the mask (M); a compaction of the mask (M); a flatness of the mask (M); the reflectivity of the mask (M); at least one critical dimension of a lithographic image of the mask (M).

12. Method according to any of claims 1-11, wherein the first electromagnetic radiation is applied from a side of the mask (M) which comprises a pattern element (P) for lithography; and/or
wherein the second electromagnetic radiation is applied from a backside of the mask (M).

13. Method according to any of claims 1-12, further comprising:
applying a third electromagnetic radiation to the mask to evoke a third material change (C3) within the mask (M) such that at least one property of the mask is modified.

14. Apparatus for correcting a reflective lithography mask (M) comprising:
means for applying a first electromagnetic radiation to the mask to evoke a first material change (C2) within the mask which modifies a reflectivity of the mask.

15. Reflective lithography mask (M), wherein the mask was corrected by a method according to any of claims 1-13.
